# EUROPEAN PATENT APPLICATION

(11) **EP 4 296 930 A1**
(43) Date of publication of application: **27.12.2023**
(21) Application number: 21926816.6
(22) Date of filing: 24.12.2021
(51) Int. Cl.: G06Q 30/06, G06Q 50/10

(54) **DATA PROCESSING SYSTEM, DATA PROCESSING METHOD, PROGRAM, AND DATA PROCESSING INTEGRATION SYSTEM**

(30) Priority: 16.02.2021 JP 2021022903
(71) Applicant: Panasonic Intellectual Property Management Co., Ltd., Osaka 571-0057 (JP)
(72) Inventor: URANO, Youji, 571-0057 Osaka (JP); NISHIMURA, Yoshinori, 571-0057 Osaka (JP); KUSUNOKI, Tomokazu, 571-0057 Osaka (JP); NISHIMURA, Kazuo, 571-0057 Osaka (JP); UENO, Ken, 571-0057 Osaka (JP); NAKATANI, Tomohiro, 571-0057 Osaka (JP)
(74) Representative: Appelt, Christian W.
(86) International application number: PCT/JP2021/048131
(87) International publication number: WO 2022/176393

(57) **Abstract**

A task of the present disclosure is to provide a user with an article capable of achieving harmony with a space. A data processing system (1) according to the present disclosure includes an acquisition unit (102) and a production unit (103). The acquisition unit (102) acquires on-site investigation data related to the space. The production unit (103) changes, with respect to article data of the article to be placed in the space, at least one of a dimension, design, and a function on the basis of the on-site investigation data so as to achieve harmony with the space and produces article processing data for processing the article according to the article data after the change. The on-site investigation data includes space-related data related to the space. The production unit (103) produces the article processing data on the basis of the space-related data.

## Description

### Technical Field

The present disclosure generally relates to a data processing system, a data processing method, a program, and a data processing integration system, and more particularly relates to a data processing system, a data processing method, a program, and a data processing integration system each for producing data for processing an article.

### Background Art

Conventionally, a system that can customize articles has been known (see, e.g., Patent Literature 1).

Patent Literature 1 describes a system having a product article number including a design article number by which, for each type of door (article), at least design of the door, positions of parts, and a wood-grain pattern of a door surface are specified. In the system in Patent Literature 1, it is possible to specify, using the product article number, a door in a pattern of intended design or the like.

In the system in Patent Literature 1, an article is designed on the basis of the predetermined product article number, and therefore harmony with a space, where the article is to be placed, may not be achieved.

### Citation List

### Patent Literature

Patent Literature 1: JP 2012-198619 A

### Summary of Invention

The present disclosure has been made in view of the problem described above, and an object thereof is to provide a data processing system, a data processing method, a program, and a data processing integration system which can provide a user with an article capable of achieving harmony with a space.

A data processing system according to an aspect of the present disclosure includes an acquisition unit and a production unit. The acquisition unit acquires on-site investigation data related to a space. The production unit changes, with respect to article data of an article to be placed in the space, at least one of a dimension, design, and a function on the basis of the on-site investigation data so as to achieve harmony with the space and produces article processing data for configuring the article according to the article data after the change. The on-site investigation data includes space-related data related to the space. The production unit produces the article processing data on the basis of the space-related data.

A data processing method according to an aspect of the present disclosure includes an acquisition step and a production step. The acquisition step includes acquiring on-site investigation data related to a space. The production step includes changing, with respect to article data of an article to be placed in the space, at least one of a dimension, design, and a function on the basis of the on-site investigation data so as to achieve harmony with the space and producing article processing data for configuring the article according to the article data after the change. The on-site investigation data includes space-related data related to the space. The production step includes producing the article processing data on the basis of the space-related data.

A program according to an aspect of the present disclosure is a program for causing a computer to implement the data processing method.

A data processing integration system according to an aspect of the present invention includes the data processing system and a plurality of article processing systems individually corresponding to a plurality of sites. The data processing system outputs the article processing data to at least one article processing system from among the plurality of article processing systems.

### Brief Description of Drawings

Fig. 1 is a block diagram illustrating a configuration of a data processing device serving as a data processing system according to an embodiment.
Fig. 2 is a diagram illustrating a system configuration of a data processing integration system including the same data processing device as above.
Fig. 3A is a diagram illustrating an example of a place where a space according to the embodiment is present, while Fig. 3B is a diagram illustrating an example of a pattern of a switch plate that is in harmony with the same space as above.
Fig. 4A is a diagram illustrating an example of a raw material of wallpaper design for the same space as above, while Fig. 4B is a diagram illustrating an example of the wallpaper design that is in harmony with the same space as above.
Fig. 5 is a sequence diagram illustrating an overall operation of the same data processing integration system as above.
Fig. 6 is a flow chart illustrating an operation of the same data processing device above.
Fig. 7 is a sequence diagram of the overall operation of the data processing integration system in a sixth modification.
Fig. 8 is a flow chart illustrating the operation of the data processing device in the sixth modification.

### Description of Embodiments

An embodiment and modifications each described below are mere examples of the present disclosure, and the present disclosure is not limited to the embodiment and the modifications. Beside the following embodiment and modifications, the present disclosure can variously be modified according to design or the like within a scope not departing from the technical idea related to the present disclosure.

### (Embodiment)

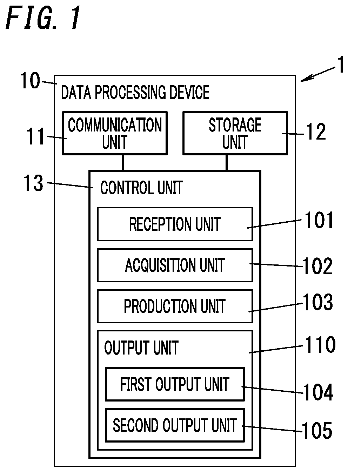

Using Figs. 1 to 8, a description will be given below of a data processing system 1 according to the present embodiment.

### (1) Overview

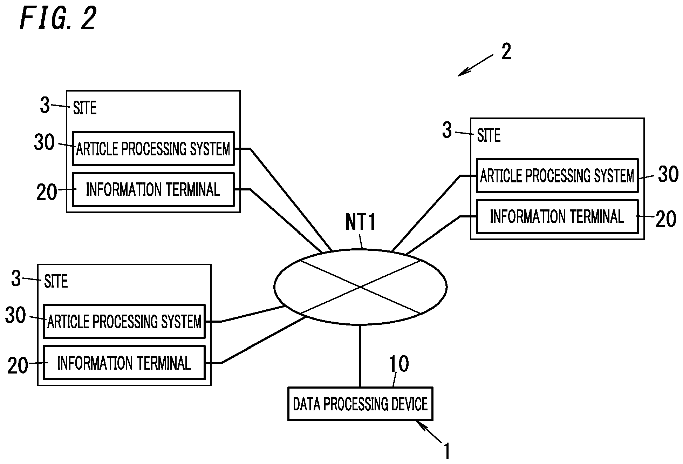

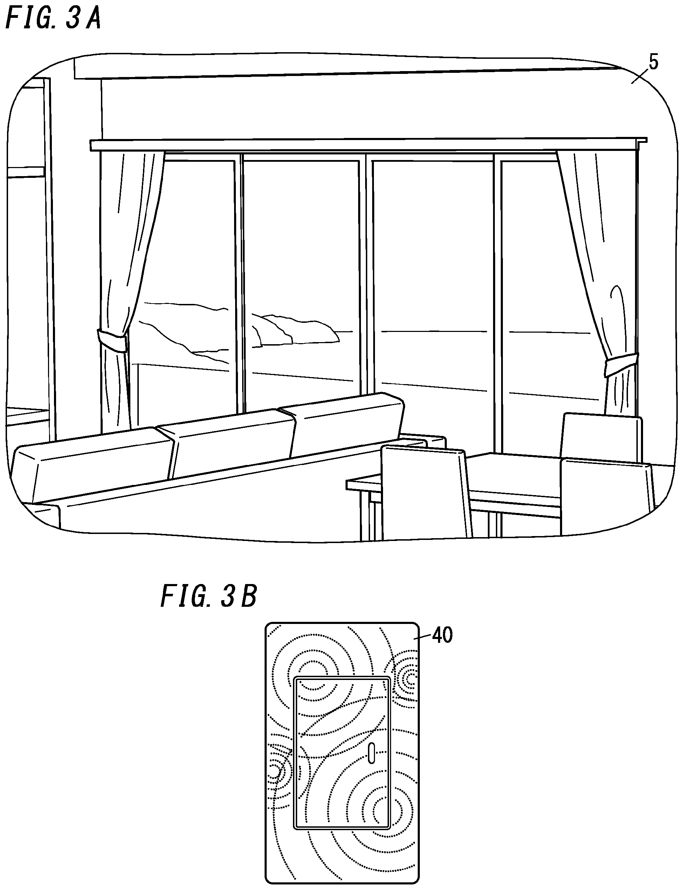

A data processing device 10 serving as the data processing system 1 changes, for an article to be placed in a space 5 (see Fig. 3A), article data of the article with respect to at least one of dimensions, design, and functions so as to achieve harmony with the space 5 to produce article processing data for processing the article according to the article data after the change. The space 5 mentioned herein is a space in a facility such as housing, which is, e.g., a living room. Note that the space 5 is not limited to a space in housing, and may also be a space in a non-residential office. The article is a fixture such as, e.g., a desk, a chair, or a shelf. The article data includes information representing each of the dimensions, design, and functions of the corresponding article (fixture). The article processing data includes a program to be used by an article processing system 30 (see Fig. 2) when the corresponding article is processed. For example, the article processing data includes a processing program when a member is subjected to cutting processing. The processing program specifies a trajectory of a path of a tool, an engraving depth, and the like. The article processing system 30 performs a cutting step or the like on the basis of the article processing data to perform processing on the corresponding article. Note that the article is not limited to the fixture. The article may also be, e.g., a building material, household equipment, an illumination light, a switch, or a home appliance.

As illustrated in Fig. 2, the data processing device 10 is configured to be communicative with each of a plurality of (three in an illustrated example) information terminals 20 and a plurality of (three in the illustrated example) article processing systems 30 which are respectively included in a plurality of (three in the illustrated example) sites 3 via a network NT 1 such as the Internet. Examples of the information terminals 20 mentioned herein include a smartphone and a tablet terminal. The information terminals 20 are operated by, e.g., a facility contractor of the facility having the space, an owner thereof, a designer of the article, and the like.

The data processing device 10, the information terminals 20, and the article processing systems 30 are included in a data processing integration system 2. In other words, the data processing integration system 2 includes the data processing device 10 (data processing system 1), the information terminals 20, and the article processing systems 30.

The data processing device 10 serving as the data processing system 1 includes an acquisition unit 102 and a production unit 103, as illustrated in Fig. 1. The acquisition unit 102 acquires on-site investigation data related to the space 5. The production unit 103 changes, with respect to the article data of the article placed in the space 5, at least one of the dimensions, design, and functions on the basis of the on-site investigation data so as to achieve harmony with the space 5. The production unit 103 produces the article processing data for processing the article according to the article data after the change. The on-site investigation data includes space-related data related to the space 5. The production unit 103 produces the article processing data on the basis of the space-related data. The on-site investigation data mentioned herein is data representing internal dimensions, shape, and the like of the space 5. The space-related data is image data resulting from image capturing performed by a 3D scanner, a camera, or the like as data representing the internal dimensions, shape, and the like of the space 5.

### (2) Configuration

### (2.1) Data Processing Device

Using Fig. 1, a description will be given herein of a configuration of the data processing device 10 serving as the data processing system 1.

As illustrated in Fig. 1, the data processing device 10 includes a communication unit 11, and a storage unit 12 serving as a management unit and a control unit 13.

The data processing device 10 includes, e.g., a microcomputer having a processor and a memory. The processor executes an appropriate program to cause a computer system to function as the control unit 13. In other words, the control unit 13 is implemented by the computer system having the processor and the memory. The program may be recorded in advance in the memory, or may also be recorded on a non-transitory recording medium such as a memory card through an electric communication line, such as the Internet, to be provided.

The communication unit 11 includes a communication interface for performing communication with each of the plurality of information terminals 20 and the plurality of article processing systems 30 via the network NT1.

The storage unit 12 is a semiconductor memory such as a ROM (Read Only Memory), a RAM (Random Access Memory), or an EEPROM (Electrically Erasable Programmable Read Only Memory). Note that the storage unit 12 is not limited to the semiconductor memory, and may also be a hard disk drive. Note that the storage unit 12 may be provided in a device other than the data processing device 10, and may also be provided in a server, a cloud, or the like connected to the data processing device 10 via a network.

The storage unit 12 stores respective article data sets of a plurality of the articles (fixtures). In addition, the storage unit 12 stores the data produced by the production unit 103, e.g., the article processing data in association with the article data.

As illustrated in Fig 1, the control unit 13 has a reception unit 101, an acquisition unit 102, a production unit 103, and an output unit 110. The output unit 110 has a first output unit 104 and a second output unit 105.

The reception unit 101 receives specification (selection) of the article for which the article processing data is to be produced among the plurality of articles (fixtures). Specifically, the reception unit 101 receives, from the information terminal 20, the specification (selection) of the article for which the article processing data is to be performed. More specifically, the reception unit 101 receives, from the information terminal 20, information (article information) related to the article received by the information terminal 20. Alternatively, the reception unit 101 may also receive the specification (selection) of the article for which the article processing data is to be performed from the information terminal operated by the facility owner.

When receiving the specification (selection) of the article for which the article processing data is to be produced, the reception unit 101 acquires the article data corresponding to the received article from the storage unit 12. More specifically, when receiving the article information from the information terminal 20, the reception unit 101 acquires, from the storage unit 12, the article data corresponding to the article represented by the received article information.

The acquisition unit 102 acquires the on-site investigation data related to the space 5. Specifically, the acquisition unit 102 acquires the on-site investigation data related to the space 5 from the information terminal 20 via the network NT1.

The production unit 103 changes, with respect to the article data of the article to be placed in the space 5, at least one of the dimensions, design, and functions on the basis of the on-site investigation data acquired by the acquisition unit 102 so as to achieve harmony with the space 5 to produce the article processing data for processing the article according to the article data after the change. The production unit 103 produces the article processing data on the basis of the space-related data included in the on-site investigation data. The production unit 103 stores, in the storage unit 12, the produced article processing data in association with the article data of the corresponding article. In other words, the storage unit 12 can manage the article processing data produced by the production unit 103 in association with the article data of the corresponding article.

For example, when the dimensions of the article are to be changed, the production unit 103 uses the on-site investigation data to specify a location where the article is to be placed and change a size of the article according to the specified placement location. The production unit 103 produces the article processing data for the article having the changed size.

Alternatively, when the design of the article is to be changed, the production unit 103 uses the on-site investigation data to change at least one of a shape, a pattern, and a color of the article according to a design style of the placement location. When the space 5 is a Japanese room, the production unit 103 changes at least one of the shape, pattern, and color of the article so as to achieve harmony with the Japanese room. The production unit 103 produces the article processing data for the article of which at least one of the article shape, pattern, and color has been changed.

When the function of the article is to be changed, the production unit 103 uses the on-site investigation data to change the function of the article according to the design style of the placement location. When the article is a desk, the production unit 103 changes the number of drawers according to the design style of the placement location. Alternatively, when the article is a chair with casters, the production unit 103 removes the casters according to the design style of the placement location. The production unit 103 produces the article processing data for the article having the function changed according to the design style of the placement location.

The production unit 103 further produces at least one set of article member processing data which is data corresponding to the article processing data and which is used when processing is performed on at least one member included in the article. The production unit 103 stores the produced at least one set of the article member processing data in association with each of the article data and the article processing data of the corresponding article. The article member processing data mentioned herein includes a program to be used by the article processing system 30 (see Fig. 2) when processing is performed on the at least one member included in the article. The article member processing data also includes at least one data among article laser processing data, article printing data, and article painting data. The article laser processing data is data to be used when laser processing is performed on the at least one member described above. The article printing data is data to be used when printing processing is performed on the at least one member described above. The article painting data is data to be used when painting processing is performed on the at least one member described above. The painting mentioned herein includes thermal spraying. In other words, the painting processing includes surface coating processing. A thermal spraying method can be selected from among various thermal spraying methods such as frame spraying, arc spraying, laser spraying, and plasma spraying in consideration of a thermal spraying target, a work environment, and the like.

When producing a plurality of sets of the article member processing data, the production unit 103 matches respective coordinate systems and origins of the plurality of sets of the article member processing data to produce the plurality of sets of the article member processing data.

For example, the production unit 103 uses the on-site investigation data to discriminate an internal design style of the space 5 and determine colored design of the article according to the discriminated design style. The production unit 103 produces the article processing data including data on the determined colored design and position information representing a position on the article member where the determined colored design is to be printed. Alternatively, when the determined colored design is to be painted, the production unit 103 produces painting data of the determined colored design. Still alternatively, when the determined colored design is implemented by laser processing, the production unit 103 produces laser processing data of the determined colored design.

The production unit 103 further produces, on the basis of the space-related data, accompanying member processing data to be used when processing is performed on an accompanying member that is a member of an accompanying article accompanying the article. The production unit 103 stores the produced accompanying member processing data in association with the article data and article processing data of the corresponding article. Examples of the accompanying member mentioned herein include wallpaper to be used for a wall of the space 5, a switch plate of a wall switch provided on the wall to be used to control an illumination lamp, and the like. The accompanying member processing data includes a program to be used by the article processing system 30 (see Fig. 2) when processing is performed on the accompanying member. The accompanying member processing data also includes at least one data among accompanying member laser processing data, accompanying member printing data, and accompanying member painting data. The accompanying member laser processing data is data to be used when laser processing is performed on the accompanying member. The accompanying member printing data is data to be used when printing processing is performed on the accompanying member. The accompanying member painting data is data to be used when painting processing is performed on the accompanying member.

When a plurality of sets of the accompanying member processing data are to be produced, the production unit 103 matches respective coordinate systems and origins of the plurality of sets of the article member processing data to produce the plurality of sets of the article member processing data.

As illustrated in Fig. 3A, when, e.g., the sea can be viewed from the space 5, the production unit 103 determines a pattern of the switch plate 40 to be a water wave pattern as illustrated n Fig. 3B. The production unit 103 produces the laser processing data such that the pattern of the switch plate 40 is the water wave pattern.

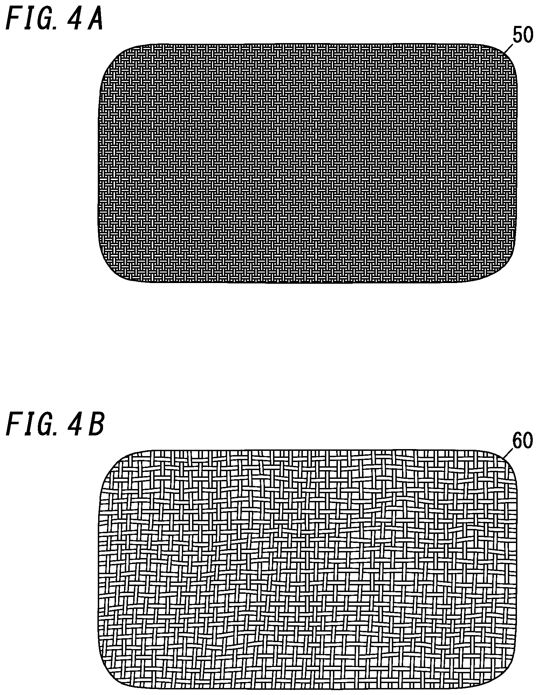

Meanwhile, when a raw material of the wallpaper design is linen 50 (see Fig. 4A), the production unit 103 produces the accompanying member processing data for wallpaper similar to the raw material of the linen 50. For example, the production unit 103 calculates an averaged colorimetric value for colors over a predetermined area (e.g., 1 cm²) of the linen 50 to be used as the wallpaper. The production unit 103 produces printing data or painting data for a color having a color difference from the calculated colorimetric value which is not more than a predetermined value. In addition, the production unit 103 produces, as the accompanying member processing data, data for producing uneven design in which a height and a pitch of unevenness of a surface of the linen 50 are adjusted to fall within ±10%. By using the printing data (or painting data) and the data for producing the uneven design even for the color having the color difference from the colorimetric value produced by the production unit 103 which is not more than the predetermined value, wallpaper 60 (see Fig. 4B) similar to the linen 50 (see Fig. 4A) is processed.

After making a change to the article data, the production unit 103 determines whether or not the article processing data, the article member processing data, and the accompanying member processing data each corresponding to the article data after the change are stored (managed) in the storage unit 12.

When determining that the article processing data, the article member processing data, and the accompanying member processing data each corresponding to the article data after the change are not stored in the storage unit 12, as described above, the production unit 103 produces the article processing data, the article member processing data, and the accompanying member processing data each corresponding to the article data after the change.

When determining that the article processing data, the article member processing data, and the accompanying member processing data each corresponding to the article data after the change are stored in the storage unit 12, the production unit 103 gives, to the second output unit 105, an instruction to output (transmit), to the article processing system 30, the article processing data, the article member processing data, and the accompanying member processing data each corresponding to the article data after the change, which are stored in the storage unit 12.

The first output unit 104 transmits the article processing data, the article member processing data, and the accompanying member processing data each corresponding to the article data after the change, which have been produced by the production unit 103, to the article processing system 30 at the site 3 including the information terminal 20 that has transmitted the on-site investigation data, which is among the plurality of article processing systems 30, via the communication unit 11.

The second output unit 105 transmits the article processing data, the article member processing data, and the accompanying member processing data each corresponding to the article data after the change, which are stored in the storage unit 12 following the instruction from the production unit 103, to the article processing system 30 at the site 3 including the information terminal 20 that has transmitted the on-site investigation data, which is among the plurality of article processing systems 30, via the communication unit 11.

### (2.2) Information Terminal

Each of the information terminals 20 includes a microcomputer including, e.g., a processor and a memory. Through execution of a program stored in the memory by the processor, the microcomputer implements functions of the information terminal 20. The program to be executed by the processor is preliminarily stored herein in the memory of the microcomputer, but may also be recorded on a non-transitory recording medium such as a memory card to be provided, or may also be provided through an electric communication line such as the Internet.

The information terminal 20 is configured to be communicative with the data processing device 10 via the network NT 1.

The information terminal 20 receives the selection of the object (fixture) for which the article processing data is to be produced through an operation of an operator (constructor). The information terminal 20 transmits information (article information) related to the received article (fixture) to the data processing device 10 via the network NT1. This allows the reception unit 101 of the data processing device 10 to receive the selection (specification) of the article (fixture) for which the article processing data is to be produced.

The information terminal 20 receives the on-site investigation data of the space 5 through the operation of the operator (constructor). The information terminal 20 transmits the received on-site investigation data to the data processing device 10 via the network NT1.

### (2.3) Article Processing System

The article processing system 30 has a microcomputer having, e.g., a processor and a memory. Through execution of a program stored in the memory by the processor, the microcomputer implements functions of the article processing system 30. The program to be executed by the processor is preliminarily stored herein in the memory of the microcomputer, but may also be recorded on a non-transitory recording medium such as a memory card to be provided, or may also be provided through an electric communication line such as the Internet.

Integration of a plurality of functions in the article processing system 30 in one housing is not a configuration indispensable to the article processing system 30, and components of the article processing system 30 may also be distributedly provided in a plurality of housings. Alternatively, at least some of the functions of the article processing system 30 may be implemented by a cloud (cloud computing) or the like.

The article processing system 30 is configured to be communicative with the data processing device 10 via the network NT 1.

The article processing system 30 receives the article processing data from the data processing device 10 via the network NT1. The article processing system 30 performs processing (cutting processing) on a member included in the article (fixture) on the basis of the received article processing data.

The article processing system 30 receives the article member processing data from the data processing device 10 via the network NT1. The article processing system 30 performs processing (such as laser processing, printing processing, or painting processing) on the member included in the article (fixture) on the basis of the received article member processing data.

The article processing system 30 receives the accompanying member processing data from the data processing device 10 via the network NT1. The article processing system 30 performs processing on the accompanying member on the basis of the received accompanying member processing data.

### (3) Operation

### (3-1) Overall Operation

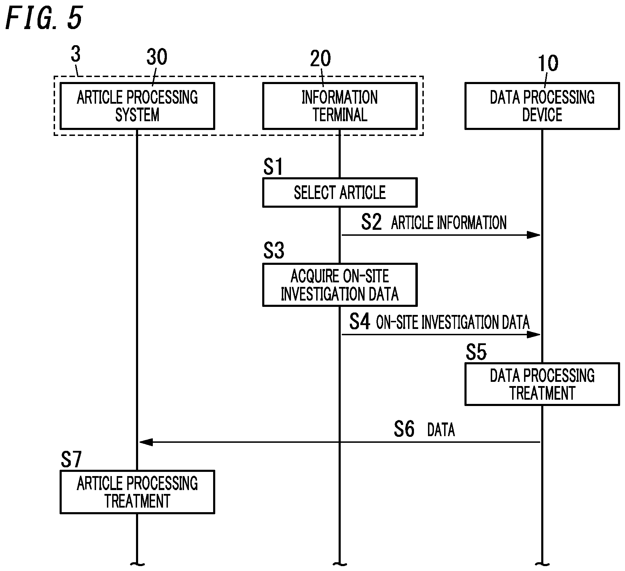

Using Fig. 5, a description will be given of an overall operation of the data processing integration system 2.

The information terminal 20 receives the selection of the article (fixture) for which the article processing data is to be produced through the operation of the operator (constructor), and transmits the article information of the received article to the data processing device 10 (Steps S1 and S2).

The information terminal 20 receives the on-site investigation data of the space 5 through the operation of the operator (constructor), and transmits the received on-site investigation data to the data processing device 10 (Steps S3 and S4).

When receiving the on-site investigation data from the information terminal 20, the data processing device 10 performs data processing treatment on the article represented by the article information (Step S5). Specifically, the data processing device 10 produces the article processing data, the article member processing data, and the accompanying member processing data.

The data processing device 10 transmits the data (the article processing data, the article member processing data, and the accompanying member processing data) for the article represented by the article information to the article processing system 30 at the site 3 including the information terminal 20 that has transmitted the on-site investigation data among the plurality of article processing systems 30 (Step S6).

When receiving the data (the article processing data, the article member processing data, and the accompanying member processing data) from the data processing device 10, the article processing system 30 performs article processing treatment (Step S7). Specifically, the article processing system 30 performs processing on the article and processing on the accompanying member on the basis of the data (the article processing data, the article member processing data, and the accompanying member processing data) received from the data processing device 10.

### (3.2) Operation of Data Processing Device

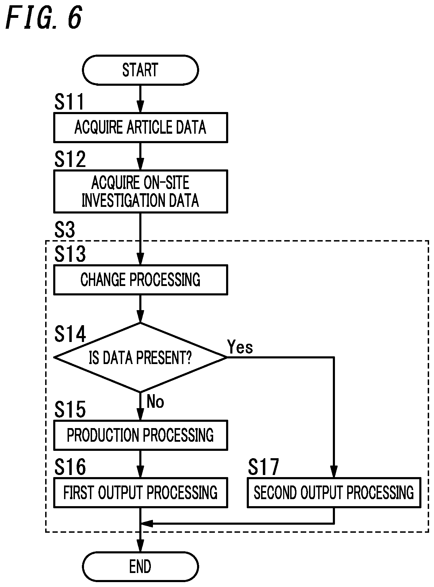

Using Fig. 6, a description will be given herein of an operation of the data processing device 10.

The reception unit 101 acquires the article data according to the article information of the article for which the article processing data is to be produced among the plurality of articles (fixtures) (Step S 11). Specifically, the reception unit 101 receives, from the information terminal 20, the article information of the article received by the information terminal 20. In other words, the reception unit 101 receives the article information transmitted in Steps S1 and S2 described above. The reception unit 101 acquires, from the storage unit 12, the article data corresponding to the article represented by the article information.

The acquisition unit 102 acquires the on-site investigation data related to the space 5 (Step S 12). Specifically, the acquisition unit 102 acquires the on-site investigation data related to the space 5 from the information terminal 20. In other words, the acquisition unit 102 acquires the on-site investigation data transmitted in Steps S3 and S4 described above.

As described above, when receiving the on-site investigation data from the information terminal 20, the data processing device 10 performs the data processing treatment shown in Step S3.

A description will be given below of the data processing treatment.

The production unit 103 performs change processing on the article for which the article processing data is to be produced (Step S13). Specifically, the production unit 103 changes, with respect to the article data acquired in Step S 11, at least one of the dimensions, design, and functions on the basis of the on-site investigation data acquired in Step S 12 so as to achieve harmony with the space 5.

After making the change to the article data, the production unit 103 determines whether or not the article processing data, the article member processing data, and the accompanying member processing data each corresponding to the article data after the change are stored (managed) in the storage unit 12 (Step S14).

When determining that the article processing data, the article member processing data, and the accompanying member processing data are not stored (not managed) in the storage unit 12 ("No" in Step S14), the production unit 103 performs data production processing (Step S15). Specifically, the production unit 103 produces the article processing data for processing the article according to the article data after the change on the basis of the space-related data included in the on-site investigation data. The production unit 103 produces at least one set of the article member processing data which is data corresponding to the article processing data and which is used when processing is performed on the at least one member included in the article. The production unit 103 further produces, on the basis of the space-related data, the accompanying member processing data to be used when processing is performed on the accompanying member which is the member accompanying the article so as to achieve harmony with the space 5. The production unit 103 stores, in the storage unit 12, the produced article processing data in association with the article data of the corresponding article. The production unit 103 stores the produced accompanying member processing data in association with the article data and the article processing data of the corresponding article. The production unit 103 stores the produced accompanying member processing data in association with the article data and the article processing data of the corresponding article.

The first output unit 104 performs first output processing (Step S 16). Specifically, the first output unit 104 transmits the article processing data, the article member processing data, and the accompanying member processing data each corresponding to the article data after the change, which have been produced by the production unit 103 in Step S15, to the article processing system 30 at the site 3 including the information terminal 20 that has transmitted the on-site investigation data.

When the production unit 103 determines that the article processing data, the article member processing data, and the accompanying member processing data are stored (managed) in the storage unit 12 ("Yes" in Step S14), the second output unit 105 performs second output processing (Step S 17). Specifically, the production unit 103 gives, to the second output unit 105, an instruction to output (transmit) to the article processing system 30 the article processing data, the article member processing data, and the accompanying member processing data each corresponding to the article data after the change, which are stored in the storage unit 12. Following the instruction from the production unit 103, the second output unit 105 transmits the article processing data, the article member processing data, and the accompanying member processing data each corresponding to the article data after the change, which are stored in the storage unit 12, to the article processing system 30 at the site 3 including the information terminal 20 that has transmitted the on-site investigation data.

### (4) Advantages

As described above, the data processing system 1 in the present embodiment includes the acquisition unit 102 and the production unit 103. The acquisition unit 102 acquires the on-site investigation data related to the space 5. The production unit 103 changes, with respect to the article data of the article to be placed in the space 5, at least one of the dimensions, design, and functions on the basis of the on-site investigation data so as to achieve the harmony with the space 5 to produce the article processing data for processing the article according to the article data after the change. The on-site investigation data includes the space-related data related to the space 5. The production unit 103 produces the article processing data on the basis of the space-related data.

With this configuration, the data processing system 1 changes, on the basis of the on-site investigation data, the article data with respect to at least one of the dimensions, design, and functions. This allows the user to be provided with the article capable of achieving harmony with the space. In other words, it is possible to reduce the possibility that no harmony is achieved with the space in which the article is to be placed.

### (5) Modifications

The following is a list of modifications. Note that the modifications described below are applicable in combination with the foregoing embodiment as appropriate.

### (5.1) First Modification

When all of the article processing data, the article member processing data, and the accompanying member processing data each corresponding to the article data after the change are managed in the storage unit 12, the production unit 103 is configured not to produce these data items, but the production unit 103 is not limited to this configuration.

The production unit 103 may also be configured to produce the unmanaged data among the article processing data, the article member processing data, and the accompanying member processing data each corresponding to the article data after the change and not to produce the managed data thereamong.

In other words, when there is at least one unmanaged data among the article processing data, the article member processing data, and the accompanying member processing data each corresponding to the article data after the change, the production unit 103 produces the at least one data. The first output unit 104 transmits the at least one produced data to the article processing system 30. The second output unit 105 outputs (transmits) the managed data to the article processing system 30.

For example, after the production unit 103 made the change to the article data, when the article processing data corresponding to the article data after the change is managed in the storage unit 12, the second output unit 105 outputs (transmits) the article processing data managed in the storage unit 12 to the article processing system 30. The production unit 103 produces the unmanaged data (e.g., the article member processing data and the accompanying member processing data) among the article processing data, the article member processing data, and the accompanying member processing data each corresponding to the article data after the change. The first output unit 104 outputs (transmits), to the article processing system 30, the data (e.g., the article member processing data and the accompanying member processing data) produced by the production unit 103.

After the production unit 103 made the change to the article data, when the article member processing data corresponding to the article data after the change is managed in the storage unit 12, the second output unit 105 outputs (transmits), to the article processing system 30, the article member processing data managed in the storage unit 12. The production unit 103 produces the unmanaged data (e.g., the article processing data and the accompanying member processing data) among the article processing data, the article member processing data, and the accompanying member processing data each corresponding to the article data after the change. The first output unit 104 outputs (transmits), to the article processing system 30, the data (e.g., the article processing data and the accompanying member processing data) produced by the production unit 103.

After the production unit 103 made the change to the article data, when the accompanying member processing data corresponding to the article data after the change is managed in the storage unit 12, the second output unit 105 further outputs (transmits), to the article processing system 30, the accompanying member processing data managed in the storage unit 12. The production unit 103 produces the unmanaged data (e.g., the article processing data and the article member processing data) among the article processing data, the article member processing data, and the accompanying member processing data each corresponding to the article data after the change. The first output unit 104 outputs (transmits), to the article processing system 30, the data (e.g., the article processing data and the article member processing data) produced by the production unit 103.

### (5.2) Second Modification

The data processing system 1 may also include the article processing system 30. In this case, the processed article or the member included in the article and processed is sent to the site 3 including the information terminal 20 that has transmitted the on-site investigation data. In addition, in the data processing system 1 in the second modification, the processed accompanying member is sent to the site 3 including the information terminal 20 that has transmitted the on-site investigation data.

### (5.3) Third Modification

A configuration is provided in which the on-site investigation data is output (transmitted) from the information terminal 20 of the constructor to the data processing device 10 (data processing system 1), but the configuration is not limited thereto.

The on-site investigation data may also be output (transmitted) from the information terminal of the facility owner to the data processing device 10 (data processing system 1).

### (5.4) Fourth Modification

A configuration is provided in which the space-related data included in the on-site investigation data is image data resulting from image capturing performed with a 3D scanner, a camera, or the like, but the configuration is not limited thereto.

The space-related data may be an actually measured dimension of the inside of the space 5 or may also be a dimension of the inside of the space 5 measured through space measurement by the information terminal 20.

### (5.5) Fifth Modification

A configuration is provided in which the first output unit 104 and the second output unit 105 are individual components, but the configuration is not limited thereto. The first output unit 104 and the second output unit 105 may also be included in one component.

### (5.6) Sixth Modification

In the embodiments described above, the article processing data, the article member processing data, and the accompanying member processing data may also be stored in association with the article data according to the on-site investigation data.

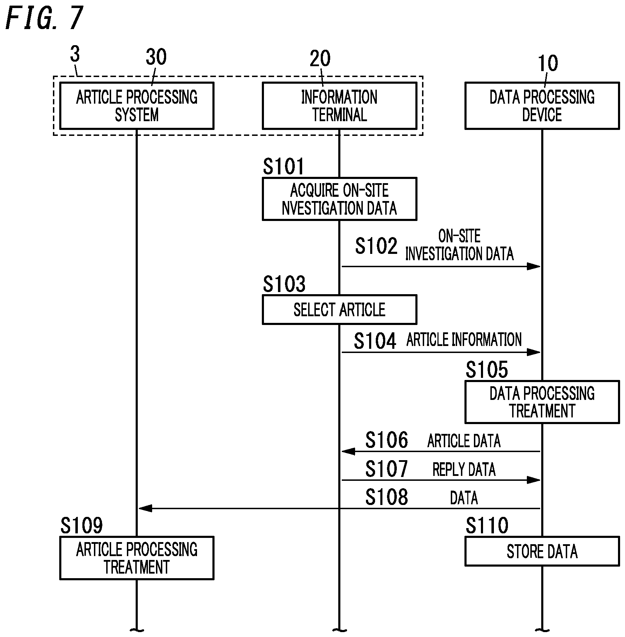

Using Fig. 7, a description will be given of an overall operation of the data processing integration system 2 in the sixth modification.

The information terminal 20 receives the on-site investigation data of the space 5 through an operation of the operator (such as, e.g., the constructor), and transmits the received on-site investigation data to the data processing device 10 (Steps S101 and S102).

The information terminal 20 receives the selection of the article (e.g., fixture) for which the article processing data is to be produced through the operation of the operator, and transmits the article information of the received article to the data processing device 10 (Steps S103 and S104).

The data processing device 10 in the sixth modification performs the data processing treatment on the article represented by the article information (Step S105).

Specifically, when the article data which is the article data of the selected article and which is according to the on-site investigation data is not present, the data processing device 10 in the sixth modification produces, in the data processing treatment, the article data, the article processing data, the article member processing data, and the accompanying member processing data. For example, the production unit 103 of the data processing device 10 in the sixth modification produces, on the basis of the on-site investigation data, the article data of the selected article. The production unit 103 in the sixth modification produces the article processing data according to the produced article data. The production unit 103 in the sixth modification produces the article processing data on the basis of the space-related data included in the on-site investigation data. The production unit 103 in the sixth modification produces the accompanying member processing data on the basis of the space-related data. Meanwhile, when the article data which is the article data of the selected article and which is according to the on-site investigation data is present, the data processing device 10 in the sixth modification acquires the article processing data, the article member processing data, and the accompanying member processing data each associated with the present article data, and outputs, to the article processing system 30, the article processing data, the article member processing data, and the accompanying member processing data.

When the article data is produced, the output unit 110 of the data processing device 10 in the sixth modification transmits the produced article data to the information terminal 20 (Step S106).

The information terminal 20 in the sixth modification produces reply data representing whether or not the operator consents to the received article data, and outputs the produced reply data to the data processing device 10.

When the replay data represents that the operator consents to the produced article data, the data processing device 10 in the sixth modification transmits the data (the article processing data, the article member processing data, and the accompanying member processing data) for the article represented by the article information to the article processing system 30 at the site 3 including the information terminal 20 that has transmitted the on-site investigation data among the plurality of article processing systems 30 (Step S107). When the reply data represents that the operator does not consent to the produced article data, the data processing device 10 in the sixth modification returns processing to Step S105. In other words, the processing repeats Steps S105 to S 107 until consent to the article data is obtained from the operator.

The article processing system 30 outputs the data (the article processing data, the article member processing data, and the accompanying member processing data) from the data processing device 10 to the article processing system 30 (Step S108).

When receiving the data (the article processing data, the article member processing data, and the accompanying member processing data) from the data processing device 10, the article processing system 30 performs the article processing treatment (Step S109). Specifically, the article processing system 30 performs processing on the article and processing on the accompanying member on the basis of the data (the article processing data, the article member processing data, and the accompanying member processing data) received from the data processing device 10.

When the article data is produced, the data processing device 10 in the sixth modification saves (stores), in the storage unit 12, the produced article data in association with the produced article processing data, article member processing data, and accompanying member processing data (Step S 110).

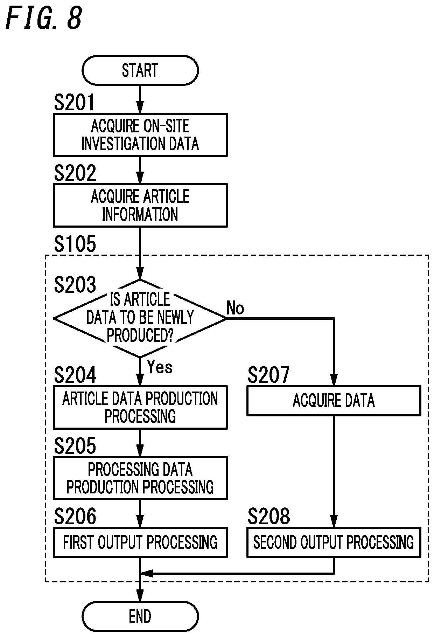

Using Fig. 8, a description will be given below of the operation of the data processing device 10 in the sixth modification.

The acquisition unit 102 acquires the on-site investigation data related to the space 5 (Step S201). Specifically, the acquisition unit 102 acquires, from the information terminal 20, the on-site investigation data related to the space 5. In other words, the acquisition unit 102 acquires the on-site investigation data transmitted in Steps S101 and S 102 described above.

The reception unit 101 acquires the article information of the article for which the article processing data is to be produced among the plurality of articles (Step S202). Specifically, the reception unit 101 receives, from the information terminal 20, the article information of the article received by the information terminal 20. In other words, the reception unit 101 receives the article information transmitted in Steps S103 and S104 described above.

The production unit 103 determines whether or not the article data is to be newly produced (Step S203). In other words, the production unit 103 determines whether or not the article data which is the article data for the acquired article information and which is according to the on-site investigation data is present.

When determining that the article data is to be newly produced ("Yes" in Step S203), i.e., when determining that the article data which is the article data for the acquired article information and which is according to the on-site investigation data is not present, the production unit 103 performs the article data production processing (Step S204). In other words, the production unit 103 produces the article data according to each of the article information and the on-site investigation data.

Then, the production unit 103 performs the data production processing (Step S205). Specifically, the production unit 103 produces, on the basis of the space-related data included in the on-site investigation data, the article processing data for processing the article according to the produced article data. The production unit 103 produces at least one set of the article member processing data which is data corresponding to the article processing data and which is used when processing is performed on at least one member included in the article. In addition, the production unit 103 produces, on the basis of the space-related data, the accompanying member processing data to be used when processing is performed on the accompanying member which is the member accompanying the article so as to achieve harmony with the space 5.

The first output unit 104 performs the first output processing (Step S206). Specifically, the first output unit 104 outputs, to the information terminal 20, the article data produced by the production unit 103 in Step S15. When obtaining consent to the article data from the operator of the information terminal 20, the first output unit 104 transmits the article processing data, the article member processing data, and the accompanying member processing data each corresponding to the article data to the article processing system 30 at the site 3 including the information terminal 20 that has transmitted the on-site investigation data.

When the production unit 103 determines that no article data is to be newly produced ("No" in Step S203), i.e., when the production unit 103 determines that the article data which is for the acquired article information and which is according to the on-site investigation data is present, the production unit 103 acquires, from the storage unit 12, the article processing data, the article member processing data, and the accompanying member processing data each associated with the present article data (step S207).

The second output unit 105 performs the second outputting processing (Step S208). Specifically, the second output unit 105 transmits the article processing data, the article member processing data, and the accompanying member processing data to the article processing system 30 at the site 3 including the information terminal 20 that has transmitted the on-site investigation data.

Further, as illustrated in Step S110, when producing the article data, the production unit 103 in the sixth modification saves (stores), in the storage unit 12, the produced article data in association with the produced article processing data, article member processing data, and accompanying member processing data.

### (5.7) Seventh Modification

An article designer or a general user may also upload (store), in the storage unit 12, the article data of an article designed by himself or herself via the network NT1.

In this case, when the article data of the article designed by the article designer or the general user is adopted, royalties may also be paid to the article designer or the general user for which the article data is adopted. This allows the article data to be expanded.

The data uploaded by the article designer or the general user may be only the article data, or may also be the article data and at least one processing data among the article processing data, the article member processing data, and the accompanying member processing data each corresponding to the article data. When the data from the article designer or the general user is uploaded, it may also be possible to determine whether the data is novel data or already uploaded data, and upload the data determined to be the novel data.

When the processing data, corresponding to the article data of the article designed by the article designer or the general user from among the article member processing data and the accompanying member data, is not stored in the storage unit 12, the data processing device 10 produces the non-stored processing data.

### (5.8) Eighth Modification

The data processing device 10 (data processing system 1) is configured to transmit the article processing data to the article processing system 30 at the site 3 including the information terminal 20 that has transmitted the on-site investigation data, but the configuration is not limited thereto.

The data processing device 10 may also transmit the article processing data to the article processing system 30 at the site 3 different from the site 3 including the information terminal 20 that has transmitted the on-site investigation data. In other words, the data processing device 10 (data processing system 1) of the data processing integration system 2 may also output (transmit) the article processing data to the article processing system 30, which is at least one of the plurality of article processing systems 30.

Note that, when the data processing device 10 (data processing system 1) outputs (transmits) the article processing data to the article processing system 30, which is at least one of the plurality of article processing systems 30, a processing start time may also be included therein. In this case, when the processing start time overlaps with a processing start time included in another article processing data, the article processing system 30 that has received the article processing data performs schedule adjustment or inventory adjustment for the produced article. When the article processing data is output (transmitted) to the article processing system 30, which is at least one of the plurality of article processing systems 30, at least one of a delivery destination and a delivery time of the article may also be further included therein. In this case, when the delivery time overlaps with a delivery time included in another article processing data, the article processing system 30 that has received the article processing data also adjusts the delivery destination and the delivery time of the produced article.

The control unit 13 of the data processing device 10 may also determine an output destination of the article processing data depending on a work load on each of the plurality of article processing systems 30. For example, the control unit 13 determines the article processing system 30 having a small work load among the plurality of article processing systems 30 as the output destination of the article processing data.

Alternatively, the data processing device 10 (data processing system 1) may also determine, on the basis of working (delivery) schedule of the article, the at least one article processing system 30 that serves as the output (transmission) destination of the article processing data among the plurality of article processing systems 30. Still alternatively, the data processing device 10 (data processing system 1) may also compare, on the basis of the article working (delivery) schedule, cost when the article is produced using a ready-made product to cost when the article is produced without using a ready-made product and propose the production of the article at optimum cost to the at least one article processing system 30 corresponding to the transmission destination of the article processing data. This can implement appropriate inventory management, article production, and distributed processing.

### (5.9) Ninth Modification

When the production unit 103 produces two or more sets of the article member processing data individually corresponding to two or more members included in the article, it may also be possible to output at least one of the two or more article member processing data sets to the article processing system 30 included in the site 3 different from the site 3 corresponding to the transmission source of the on-site investigation data. Alternatively, it may also be possible to change, for each one of the two or more produced article member processing data sets, the output destination of the article member processing data set.

When the production unit 103 produces the two or more sets of the accompanying member processing data individually corresponding to two or more members (accompanying members) included in the accompanying article accompanying the article, it may also be possible to output at least one of the two or more accompanying member processing data sets to the article processing system 30 included in the site 3 different from the site 3 corresponding to the transmission source of the on-site investigation data. Alternatively, it may also be possible to change, for each one of the two or more produced accompanying member processing data sets, the output destination of the accompanying member processing data set.

### (5.10) Tenth Modification

When producing the article processing data, in a case where the article to be placed in the space 5 can be produced using a ready-made product, the production unit 103 may also produce the article processing data on the basis of a difference between the article to be placed in the space 5 and the ready-made product. In a case where the article to be placed in the space 5 can be produced from a plurality of ready-made products, it may also be possible to determine a difference between the article to be placed in the space 5 and each of the ready-made products and produce the article processing data on the basis of the difference with each of the ready-made products.

### (5.11) Eleventh Modification

The article processing data produced by the production unit 103 may also include, in addition to data on the determined colored design of the article and position information representing a position on the article member where the determined colored design is to be printed, each of article design, a processing procedure, an assembly procedure, and a working procedure.

This allows a procedure from the determination of the article design to installation (working) to be determined, and therefore it is possible to promote smooth working.

### (5.12) Twelfth Modification

The article data may also include information related to a functionality of a material to be used for the article. For example, the article data may also include information related to features of a material to be used for the article. The features of the material to be used for the article are that the material has an aromatic effect, the material is resistant to water, and the like. When the material is wood, the feature of the material to be used for the article is a wood grain direction for ensuring a strength of the article.

### (5.13) Thirteenth Modification

The storage unit 12 may also store, as the article data, data of the article according to seasons and events. When the space 5 in which the article is to be placed is a space in a store, the articles according to seasons and events are regularly proposed to the store.

### (5.14) Fourteenth Modification

The storage unit 12 may also store the article data of an article (specified article) that cannot be produced without using a specified material (raw material). The specified article is an article including a shape that cannot be formed without using the specified material (raw material). In this case, the article data of the specified article includes a brief description of design that is possible with the specified material (raw material), but is not possible with another material (raw material). For example, when receiving a content that is normally impossible, in a case where the article data of one or more specified articles according to the content is stored in the storage unit 12, the data processing device 10 (data processing system 1) outputs (proposes) the article data of the one or more specified articles.

### (5.15) Fifteenth Modification

Even when the article uses a material that cannot normally be used in an environment in which the article is to be placed, in a case where the material can be used if specified processing is performed on the material, the data processing device 10 (data processing system 1) may also output (propose) the article data of the article using the material.

For example, in a space where frequent disinfection and cleaning is required, a material such as leather, wood, or paper cannot normally be used. However, by adding texture decoration with a molding resin or the like to a surface of the material, even in a space where disinfection and cleaning is required, the material becomes usable. In this case, the data processing device 10 (data processing system 1) outputs the article data of the article which is to be placed in a space where disinfection and cleaning is required and which uses a material such as leather, wood, or paper.

When a material (substitute material) that can be a substitute for a material unusable in an environment in which the article is to be placed is present, the data processing device 10 (data processing system 1) may also output (propose) the article data of the article using the substitute material. For example, when the article to be placed in the space 5 has a large size and is to be placed at a high place, a ceramic member cannot normally be used. However, when a crack-resistant and light-weight ceramic-like resin panel is used, the large-sized article mentioned above can be produced. In this case, when the large-sized article that cannot normally be produced with a ceramic member can be produced using the ceramic-like resin panel, the data processing device 10 (data processing system 1) outputs (proposes) the article data of the large-sized article mentioned above. At this time, the article data includes a statement that the large-sized article mentioned above can be produced using the ceramic-like resin panel.

### (5.16) Sixteenth Modification

Before the article scheduled to be placed is worked, the data processing device 10 (data processing system 1) may also display, on a display device or the like, an image (superimposed image) obtained by superimposing the article scheduled to be placed on an image of the space 5 and allow an owner of the facility or the like to check the image.

When there is a discrepancy between harmony of the design of the article with the space 5 imaged by the facility owner and harmony of the design of the article with the space 5 represented by the superimposed image, the facility owner can give an instruction to change the design of the article. This allows the facility owner to place the article that satisfies the facility owner to be placed in the space 5.

The data processing device 10 (data processing system 1) may also have a learning function herein. In this case, after displaying the superimposed image on the display device or the like, when receiving the change instruction, the data processing device 10 (data processing system 1) changes the design of the article. The data processing device 10 (data processing system 1) uses the article data after the change as instruction data to perform leaning of the article data suitable for the space 5.

### (5.17) Seventeenth Modification

In a case of a newly-built facility, the on-site investigation data of the space 5 in the facility may not be able to be obtained. In this case, after producing the article data, the data processing device 10 (data processing system 1) may also acquire the on-site investigation data of the space 5 when on-site investigation becomes possible in the space 5 and correct the article data. Alternatively, after the article processing system 30 produces a fixture on the basis of the article data or the like and the produced fixture is carried in the space 5, a worker or the like may also adjust the fixture. Still alternatively, after the facility is completed, the data processing device 10 (data processing system 1) may also acquire the on-site investigation data of the space 5 and produce the article data.

It may also be possible that, since there is a blueprint of the facility, the facility owner or the like determines that on-site investigation is unnecessary. In this case, after the article processing system 30 produces the fixture on the basis of the article data or the like and after the produced fixture is carried in the space 5, the worker or the like may also adjust the fixture.

### (Other Modifications)

The embodiments described above are merely among various embodiments of the present disclosure. The embodiments described above can variously be modified according to design or the like as long as the object of the present disclosure can be attained. In addition, the same functions as those of the data processing system 1 may also be implemented by a data processing method, a computer program, a non-transitory recording medium on which the program is recorded, or the like.

A data processing method for the data processing system 1 according to an aspect includes an acquisition step and a production step. The acquisition step includes acquiring on-site investigation data related to the space 5. The production step includes changing, with respect to article data of an article to be placed in the space, at least one of a dimension, design, and a function on the basis of the on-site investigation data so as to achieve harmony with the space to produce article processing data for configuring the article according to the article data after the change. The on-site investigation data includes space-related data related to the space 5. The production step includes producing the article processing data on the basis of the space-related data. A program according to an aspect is a program for causing a computer system to function as the data processing system 1 described above or the data processing method for the data processing system 1.

The data processing system 1 or an executing body of the data processing method for the data processing system 1 in the present disclosure includes the computer system. The computer system has a processor and a memory each as hardware. Execution of the program recorded in the memory of the computer system by the processor implements a function of the data processing system 1 or the executing body of the data processing method for the data processing system 1 in the present disclosure. The program may be recorded in advance in the memory of the computer system, but may also be provided through an electric communication line. Alternatively, the program may also recorded on a non-transitory recording medium readable by the computer system, such as a memory card, an optical disk, or a hard disk drive, to be provided. The processor of the computer system includes one or a plurality of electronic circuits each including a semiconductor integrated circuit (IC) or a large-scale integrated circuit (LSI). The integrated circuit mentioned herein, such as the IC or LSI, is referred to differently depending on a degree of integration, and includes an integrated circuit referred to as a system LSI, VLSI (Very Large Scale Integration), or a ULSI (Ultra Large Scale Integration). A FPGA (Field-Programmable Gate Array) that is programmed after manufacturing of the LSI or a logic device in which a junction relationship in the LSI can be reconfigured or a circuit partition in the LSI can be reconfigured can also be adopted as the processor. The plurality of electronic circuits may be integrated in one chip or may also be distributedly provided in a plurality of chips. The plurality of chips may be integrated in one device, or may also be distributedly provided in a plurality of devices.

In addition, integration of a plurality of functions in the data processing system 1 in one housing is not a configuration indispensable to the data processing system 1, and the components of the data processing system 1 may also be distributedly provided in a plurality of housings. Alternatively, at least some of the functions of the data processing system 1 may also be implemented by a cloud (cloud computing) or the like.

### (Summation)

As described above, the data processing system (1) in a first aspect includes an acquisition unit (102) and a production unit (103). The acquisition unit (102) acquires on-site investigation data related to a space (5). The production unit (103) changes, with respect to article data of an article to be placed in the space (5), at least one of a dimension, design, and a function on the basis of the on-site investigation data so as to achieve harmony with the space (5) to produce article processing data for processing the article according to the article data after the change. The on-site investigation data includes space-related data related to the space (5). The production unit (103) produces the article processing data on the basis of the space-related data.

With this configuration, it is possible to provide a user with an article capable of achieving harmony with the space (5). In addition, when the article is produced, by merely changing at least one of the design and function of the article so as to achieve harmony with the space (5), it is possible to easily produce the article processing data without needing know-how and a skill each related to the change of the article so as to achieve harmony with the space (5).

In the data processing system (1) in a second aspect, in the first aspect, the production unit (103) further produces at least one set of article member processing data which is data corresponding to the article processing data and which is used when processing is performed on at least one member included in the article.

With this configuration, it is possible to change colored design, a texture, and the like of the article so as to achieve harmony with the space (5).

In the data processing system (1) in a third aspect, in the second aspect, when producing a plurality of sets of the article member processing data, the production unit (103) matches respective coordinate systems and origins of the plurality of sets of article member processing data to produce the plurality of sets of article member processing data.

With this configuration, as a result of matching the respective coordinate systems and origins of the plurality of sets of article member processing data, the member need not be set again every time the use of one of the article member processing data sets is ended, and continuous processing becomes possible.

In the data processing system (1) in a fourth aspect, in the second or third aspect, the article member processing data includes at least one data among article laser processing data, article printing data, and article painting data. The article laser processing data is data to be used when laser processing is performed on the at least one member. The article printing data is data to be used when printing processing is performed on the at least one member. The article painting data is data to be used when painting processing is performed on the at least one member.

With this configuration, it is possible to change the colored design, texture, and the like of the article so as to achieve harmony with the space (5).

In the data processing system (1) in a fifth aspect, in any of the first to fourth aspects, the production unit (103) produces accompanying member processing data. The accompanying member processing data is data to be used when processing is performed on an accompanying member which is a member accompanying the article on the basis of the space-related data so as to achieve harmony with the space (5).

With this configuration, it is possible to change colored design, a texture, and the like of the accompanying member so as to achieve harmony with the space (5).

In the data processing system (1) in a sixth aspect, in the fifth aspect, when producing a plurality of sets of the accompanying member processing data, the production unit (103) matches respective coordinate systems and origins of the plurality of sets of accompanying member processing data to produce the plurality of sets of accompanying member processing data.

With this configuration, as a result of matching the respective coordinate systems and origins of the plurality of sets of the accompanying member processing data, the accompanying member need not be set again every time the use of one of the accompanying member processing data sets is ended, and continuous processing becomes possible.

In the data processing system (1) in a seventh aspect, in the fifth or sixth aspect, the accompanying member processing data includes at least one data among accompanying member laser processing data, accompanying member printing data, and accompanying member painting data. The accompanying member laser processing data is data to be used when laser processing is performed on the accompanying member. The accompanying member printing data is data to be used when printing processing is performed on the accompanying member. The accompanying member painting data is data to be used when painting processing is performed on the accompanying member.

With this configuration, it is possible to change the colored design, texture, and the like of the accompanying member so as to achieve harmony with the space (5).

The data processing system (1) in an eighth aspect further includes, in any of the first to seventh aspects, an output unit (110) that outputs the article processing data produced by the production unit (103).

With the configuration, it is possible to provide the user with the article data of the article that is the article data produced to be capable of achieving harmony with the space (5).

The data processing system (1) in a ninth aspect further includes, in the eighth aspect, a management unit (e.g., a storage unit 12). The management unit manages the article processing data. After the production unit (103) makes the change to the article data, when the article processing data corresponding to the article data after the change is managed in the management unit, the output unit (110) outputs the article processing data managed in the management unit.

With this configuration, it is possible to extensively use existing article processing data and accordingly reduce a data production time.

In the data processing system (1) in a tenth aspect, in the ninth aspect, the management unit further manages article member processing data which is data corresponding to the article processing data and which is used when processing is performed on at least one member included in the article. When the article member processing data corresponding to the article data after the change is managed in the management unit, the output unit further outputs the article member processing data managed in the management unit.

With this configuration, it is possible to extensively use existing article member processing data and accordingly reduce a data production time.

In the data processing system (1) in an eleventh aspect, in the ninth or tenth aspect, the management unit further manages accompanying member processing data. The accompanying member processing data is data to be used when processing is performed on an accompanying member which is a member accompanying the article so as to achieve harmony with the space (5). When the accompanying member processing data corresponding to the article data after the change is managed in the management unit, the output unit further outputs the accompanying member processing data managed in the management unit.

With this configuration, it is possible to extensively use existing accompanying member processing data and accordingly reduce a data production time.

In the data processing system (1) in a twelfth aspect, in any of the eighth to eleventh aspects, the output unit (110) outputs the article data.

With this configuration, by, e.g., outputting the article data to the information terminal (20) that has transmitted the on-site investigation data, an operator of the information terminal (20) can check the article data of the article. As a result, the operator of the information terminal (20) can check whether or not the article capable of achieving harmony with the space (5) can be obtained.

In the data processing system (1) in a thirteenth aspect, in any of the first to twelfth aspects, the article is a fixture.

With this configuration, it is possible to provide the fixture that is in harmony with the space (5).

A data processing method in a fourteenth aspect includes an acquisition step and a production step. The acquisition step includes acquiring on-site investigation data related to a space (5). The production step includes changing, with respect to article data of an article to be placed in the space (5), at least one of a dimension, design, and a function on the basis of the on-site investigation data so as to achieve harmony with the space (5) to produce article processing data for configuring the article according to the article data after the change. The on-site investigation data includes space-related data related to the space (5). The production step includes producing the article processing data on the basis of the space-related data.

With this data processing method, it is possible to provide a user with an article capable of achieving harmony with the space. In addition, by merely changing at least one of the design and function of the article so as to achieve harmony with the space (5) when the article is produced, it is possible to easily produce the article processing data without needing know-how and a skill each related to the change of the article so as to achieve harmony with the space (5).

A program in a fifteenth aspect is a program for causing a computer to implement the data processing method in the fourteenth aspect.

With this program, it is possible to provide the user with the article capable of achieving harmony with the space. In addition, by merely changing at least one of the design and function of the article so as to achieve harmony with the space (5) when the article is produced, it is possible to easily produce the article processing data without needing know-how and a skill each related to the change of the article so as to achieve harmony with the space (5).

A data processing integration system (2) in a sixteenth aspect includes the data processing system (1) in any one of the first to thirteenth aspects and a plurality of article processing systems (30) individually corresponding to a plurality of sites (3). The data processing system (1) outputs the article processing data to the article processing system (30), which is at least one of the plurality of article processing systems (30).

With this configuration, it is possible to provide the user with the article capable of achieving harmony with the space (5). In addition, by merely changing at least one of the design and function of the article so as to achieve harmony with the space (5) when the article is produced, it is possible to easily produce the article processing data without needing know-how and a skill each related to the change of the article so as to achieve harmony with the space (5).

In the data processing integration system (2) in a seventeenth aspect, in the sixteenth aspect, an output destination of the article processing data is the article processing system (30) included in the site (3) corresponding to a transmission source of the on-site investigation data.

With this configuration, when, e.g., the site (3) as the transmission source of the on-site investigation data is closer to a working place in a facility than another site, it is possible to reduce transportation cost and a transportation time of the article.

In the data processing integration system (2) in an eighteenth aspect, in the sixteenth or seventeenth aspect, the data processing system (1) determines an output destination of the article processing data depending on a work load on each of the plurality of article processing systems (30).

With this configuration, by determining the article processing system (30) having a small working load among the plurality of article processing systems (30) to be the output destination of the article processing data, it is possible to increase a productivity efficiency.

In the data processing integration system (2) in a nineteenth aspect, in any of the sixteenth to eighteenth aspects, the production unit (103) produces at least one set of article member processing data which is data corresponding to the article processing data and which is used when processing is performed on at least one member included in the article. When two or more sets of the article member processing data individually corresponding to two or more members included in the article are produced, the data processing system (1) outputs at least one of the two or more sets of the article member processing data to the article processing system (30) included in the site (3) different from the site (3) serving as a transmission source of the on-site investigation data.

With this configuration, it is possible to process a plurality of the article members at different sites. Accordingly, processing and variations of the article increase. In addition, there is no more need to have a plurality of facilities for the individual sites (3) to be able to suppress facility investment.

### Reference Signs List

- 1: Data processing system
- 2: Data processing integration system
- 5: Space
- 12: Storage unit (management unit)
- 10: Data processing device
- 20: Information terminal
- 30: Article processing system
- 102: Acquisition unit
- 103: Production unit
- 110: Output unit

## Claims

1. A data processing system comprising:
an acquisition unit that acquires on-site investigation data related to a space; and
a production unit that changes, with respect to article data of an article to be placed in the space, at least one of a dimension, design, and a function on the basis of the on-site investigation data so as to achieve harmony with the space and produces article processing data for processing the article according to the article data after the change,
the on-site investigation data including space-related data related to the space,
the production unit producing the article processing data on the basis of the space-related data.

2. The data processing system according to claim 1, wherein the production unit further produces at least one set of article member processing data, which is data corresponding to the article processing data and which is used when processing is performed on at least one member configuring the article.

3. The data processing system according to claim 2, wherein, when producing a plurality of sets of the article member processing data, the production unit matches respective coordinate systems and origins of the plurality of sets of article member processing data to produce the plurality of sets of article member processing data.

4. The data processing system according to claim 2 or 3, wherein the article member processing data includes at least one data among article laser processing data to be used when laser processing is performed on the at least one member, article printing data to be used when printing processing is performed on the at least one member, and article painting data to be used when painting processing is performed on the at least one member.

5. The data processing system according to any one of claims 1 to 4, wherein the production unit produces accompanying member processing data to be used when processing is performed on an accompanying member, which is a member accompanying the article, on the basis of the space-related data so as to achieve harmony with the space.

6. The data processing system according to claim 5, wherein, when producing a plurality of sets of the accompanying member processing data, the production unit matches respective coordinate systems and origins of the plurality of sets of accompanying member processing data to produce the plurality of sets of accompanying member processing data.

7. The data processing system according to claim 5 or 6, wherein the accompanying member processing data includes at least one data among accompanying member laser processing data to be used when laser processing is performed on the accompanying member, accompanying member printing data to be used when printing processing is performed on the accompanying member, and accompanying member painting data to be used when painting processing is performed on the accompanying member.

8. The data processing system according to any one of claims 1 to 7, further comprising:
an output unit that outputs the article processing data produced by the production unit.

9. The data processing system according to claim 8, further comprising:
a management unit that manages the article processing data, wherein
after the production unit makes the change to the article data, when the article processing data corresponding to the article data after the change is managed in the management unit, the output unit outputs the article processing data managed in the management unit.

10. The data processing system according to claim 9, wherein
the management unit further manages article member processing data, which is data corresponding to the article processing data and which is used when processing is performed on at least one member configuring the article, and,
when the article member processing data corresponding to the article data after the change is managed in the management unit, the output unit further outputs the article member processing data managed in the management unit.

11. The data processing system according to claim 9 or 10, wherein
the management unit further manages, on the basis of the space-related data, accompanying member processing data to be used when processing is performed on an accompanying member, which is a member accompanying the article, so as to achieve harmony with the space, and,
when the accompanying member processing data corresponding to the article data after the change is managed in the management unit, the output unit further outputs the accompanying member processing data managed in the management unit.

12. The data processing system according to any one of claims 8 to 11, wherein the output unit outputs the article data.

13. The data processing system according to any one of claims 1 to 12, wherein the article is a fixture.

14. A data processing method comprising:
an acquisition step of acquiring on-site investigation data related to a space; and
a production step of changing, with respect to article data of an article to be placed in the space, at least one of a dimension, design, and a function on the basis of the on-site investigation data so as to achieve harmony with the space and producing article processing data for configuring the article according to the article data after the change,
the on-site investigation data including space-related data related to the space, and
the production step including producing the article processing data on the basis of the space-related data.

15. A program for causing a computer to implement the data processing method according to claim 14.

16. A data processing integration system comprising:
the data processing system according to any one of claims 1 to 13; and
a plurality of article processing systems individually corresponding to a plurality of sites,
the data processing system outputting the article processing data to at least one article processing system from among the plurality of article processing systems.

17. The data processing integration system according to claim 16, wherein an output destination of the article processing data is the article processing system included in the site corresponding to a transmission source of the on-site investigation data.

18. The data processing integration system according to claim 16 or 17, wherein the data processing system determines an output destination of the article processing data depending on a work load on each of the plurality of article processing systems.

19. The data processing integration system according to any one of claims 16 to 18, wherein
the production unit produces at least one set of article member processing data, which is data corresponding to the article processing data and which is used when processing is performed on at least one member configuring the article, and,
when two or more sets of the article member processing data individually corresponding to two or more members configuring the article are produced, the data processing system outputs at least one of the two or more sets of the article member processing data to the article processing system included in the site different from the site serving as a transmission source of the on-site investigation data.
